# EUROPEAN PATENT APPLICATION

(11) **EP 4 618 083 A2**
(43) Date of publication of application: **17.09.2025**
(21) Application number: 25163690.8
(22) Date of filing: 14.03.2025
(51) Int. Cl.: G11C 7/14, G11C 11/16, G11C 17/04, G11C 17/16, G11C 17/18

(54) **MAGNETIC TUNNEL JUNCTION ANTI-FUSE INCLUDING NON-MAGNETIC STACK**

(30) Priority: 15.03.2024 US 202463565871 P; 07.03.2025 US 202519073454
(71) Applicant: Everspin Technologies, Inc., Chandler, Arizona 85226 (US)
(72) Inventor: NAGEL, Kerry Joseph, Chandler, AZ, 85226 (US); SUN, Jijun, Chandler, AZ, 85226 (US); SADD, Michael A., Chandler, AZ, 85226 (US); ALAM, Syed M., Chandler, AZ, 85226 (US)
(74) Representative: Eisenführ Speiser

(57) **Abstract**

An antifuse device may comprise an antifuse bit including: a first non-magnetic conductive layer, an insulator above the first non-magnetic conductive layer, and a second non-magnetic conductive layer above the insulator, wherein when the insulator is disrupted, the first non-magnetic conductive layer and the second non-magnetic conductive layer permanently conduct an electrical current from one to another.

## Description

### CROSS-REFERENCE TO RELATED APPLICATION

This application claims benefit to U.S. Provisional Patent Application No. 63/565,871 filed March 15, 2024, the entire contents of which are incorporated herein by reference.

### TECHNICAL FIELD

Various embodiments of the present disclosure relate generally to a magnetoresistive device and, more particularly, to a fuse including non-magnetic conductive layers in a magnetoresistive device.

### INTRODUCTION

In general, a memory system may include a memory device for storing data and a host (or controller) for controlling operations of the memory device. Memory devices may be classified into, e.g., volatile memory (such as, e.g., DRAM or SRAM) and non-volatile memory (such as EEPROM, FRAM (Ferroelectric RAM), PRAM (Phase-change memory), MRAM (magnetoresistive memory), RRAM/ReRAM (resistive memory) and Flash memory).

A magnetoresistive stack used in a memory device (e.g., MRAM) includes at least one non-magnetic layer (for example, at least one dielectric layer or a non-magnetic yet electrically conductive layer) disposed between a "fixed" magnetic region and a "free" magnetic region, each including one or more layers of ferromagnetic materials. Such magnetoresistive stack is often referred to as a magnetoresistive tunnel junction (MTJ). Information is stored in the magnetoresistive memory stack by switching, programming, and/or controlling the direction of magnetization vectors in the magnetic layer(s) of the free magnetic region. The direction of the magnetization vectors of the free magnetic region may be switched and/or programmed (for example, through spin orbit torque (SOT) and/or spin transfer torque (STT)) by application of a write signal (e.g., one or more current pulses) adjacent to, or through, the magnetoresistive memory stack.

Each integrated circuit chip may include billions of devices thereon, including memory devices such as transistors, resistors, capacitors, and an MTJ. Fuses and antifuses are often integrated into complex circuitry for a variety of purposes, including for selective blowing of fuses or selective shorting of circuit components for specific applications. MTJs are often used as antifuses or fuses, due to, for example, their capability to act as permanent conductors when a threshold current is passed through them. Accordingly, it is desirable to create more robust MTJ-like antifuse or fuse designs while minimizing costs and complexity.

### BRIEF DESCRIPTION OF DRAWINGS

In the course of the detailed description that follows, reference will be made to the appended drawings. The drawings show different aspects of the present disclosure and, where appropriate, reference numerals illustrating like structures, components, materials, and/or elements in different figures are labeled similarly. It is understood that various combinations of the structures, components, and/or elements, other than those specifically shown, are contemplated and are within the scope of the present disclosure.

Moreover, there are many embodiments of the present disclosure described and illustrated herein. The present disclosure is neither limited to any single aspect nor embodiment thereof, nor to any combinations and/or permutations of such aspects and/or embodiments. Moreover, each of the aspects of the present disclosure, and/or embodiments thereof, may be employed alone or in combination with one or more of the other aspects of the present disclosure and/or embodiments thereof. For the sake of brevity, certain permutations and combinations are not discussed and/or illustrated separately herein; however, all permutations and combinations are considered to fall within the scope of the present inventions.
FIG. 1 depicts an exemplary circuit diagram including an antifuse circuit.
FIG. 2 depicts an exemplary timing diagram for the exemplary antifuse circuit of FIG. 1.
FIG. 3 depicts an exemplary block diagram of an antifuse system.
FIG. 4 depicts an exemplary antifuse circuit.
FIG. 5 depicts an exemplary antifuse device, according to an aspect of the present disclosure.
FIG. 6A and 6B depict an exemplary integrated circuit (IC) device including an antifuse circuit, according to an aspect of the present disclosure.

Again, there are many embodiments described and illustrated herein. The present disclosure is neither limited to any single aspect nor embodiment thereof, nor to any combinations and/or permutations of such aspects and/or embodiments. Each of the aspects of the present disclosure, and/or embodiments thereof, may be employed alone or in combination with one or more of the other aspects of the present disclosure and/or embodiments thereof. For the sake of brevity, many of those combinations and permutations are not discussed separately herein.

### DETAILED DESCRIPTION

Detailed illustrative aspects are disclosed herein. However, specific structural and functional details disclosed herein are merely representative for purposes of describing example embodiments of the present disclosure. The present disclosure may be embodied in many alternate forms and should not be construed as limited to only the embodiments set forth herein. Further, the terminology used herein is for the purpose of describing particular embodiments only and is not intended to be limiting of exemplary embodiments described herein.

When the specification makes reference to "one embodiment" or to "an embodiment," it is intended to mean that a particular feature, structure, characteristic, or function described in connection with the embodiment being discussed is included in at least one contemplated embodiment of the present disclosure. Thus, the appearance of the phrases, "in one embodiment" or "in an embodiment," in different places in the specification does not constitute a plurality of references to a single embodiment of the present disclosure.

As used herein, the terms "comprises," "comprising," or any other variation thereof, are intended to cover a non-exclusive inclusion, such that a process, method, article, or apparatus that comprises a list of elements does not include only those elements, but may include other elements not expressly listed or inherent to such process, method, article, or apparatus. The term "exemplary" is used in the sense of "example," rather than "ideal."

As used herein, the singular forms "a," "an," and "the" are intended to include the plural forms as well, unless the context clearly indicates otherwise. It also should be noted that in some alternative implementations, the features and/or steps described may occur out of the order depicted in the figures or discussed herein. For example, two steps or figures shown in succession may instead be executed substantially concurrently or may sometimes be executed in the reverse order, depending upon the functionality/acts involved. In some aspects, one or more described features or steps may be omitted altogether, or may be performed with an intermediate step therebetween, without departing from the scope of the embodiments described herein, depending upon the functionality/acts involved.

Further, the terms "first," "second," and the like, herein do not denote any order, quantity, or importance, but rather are used to distinguish one element from another. Similarly, terms of relative orientation, such as "top," "bottom," etc. are used with reference to the orientation of the structure illustrated in the figures being described. It should also be noted that all numeric values disclosed herein may have a variation of ±10% (unless a different variation is specified) from the disclosed numeric value. Further, all relative terms such as "about," "substantially," "approximately," etc. are used to indicate a possible variation of ±10% (unless noted otherwise or another variation is specified).

In one aspect, the present disclosure is directed to techniques and implementations for fuses made from non-magnetic memory device layers, and, more particularly, to systems and methods for an antifuse bit including a first non-magnetic conductive layer, an insulator above the first non-magnetic conductive layer, and a second non-magnetic conductive layer above the insulator.

Fuses and antifuses are important devices in integrated circuits, providing numerous functions, including for selective blowing of fuses or selective shorting of circuit components for specific applications. Currently, polysilicon resistors as well as MTJs are used as fuses or antifuses. However, the polysilicon resistors require high voltages to blow the fuse, which may cause damage to surrounding circuit components, and the MTJs usually have a complex magnetic stack with numerous layers (e.g., including electrodes, seed layers, free magnetic layers, fixed magnetic layers, insulating layers, etc.), leading to unnecessary cost and complexity.

Accordingly, it may be desirable to create robust MTJ antifuse or fuse designs while minimizing defect risk, manufacturing complexity, and costs.

In one aspect, a reference used for reading the state of an MTJ antifuse may include unprogrammed MTJ devices in parallel to set a reference resistance. The MTJs in parallel may provide a resistance that may be between the programmed and unprogrammed resistance of the MTJ antifuse. With the reference being made up of a similar construction as the MTJ antifuse, the reference may be relatively effective in tracking the changes in operating characteristics due to variations in the manufacturing process. Further, the number of MTJ devices in parallel may be selectable so that the resistance level may be adjusted to obtain an optimum reference resistance. This may be particularly significant due to the variation in resistance among the unprogrammed MTJ antifuses. In some embodiments, the reference may include just one MTJ device. In some other embodiment, the reference may include one or more resistors that are not in the form of MTJs. The reference resistance may need to be detectably below the unprogrammed resistance of an MTJ antifuse with the lowest unprogrammed resistance. The reference and MTJ antifuse may be protected from the higher voltage used in the sense amplifier by a pass transistor that may be made to handle higher voltages in order to protect the MTJ devices from the higher voltage that could exceed the breakdown voltage of the MTJ devices. Similarly, these pass devices may also protect the sense amplifier from the somewhat high voltages used by a write circuit during programming. Also, the write circuit may respond to a breakdown of the MTJ antifuse by reducing the current flow, which may enable the current to more quickly be used elsewhere. This is better understood with reference to the FIGS. and the following description.

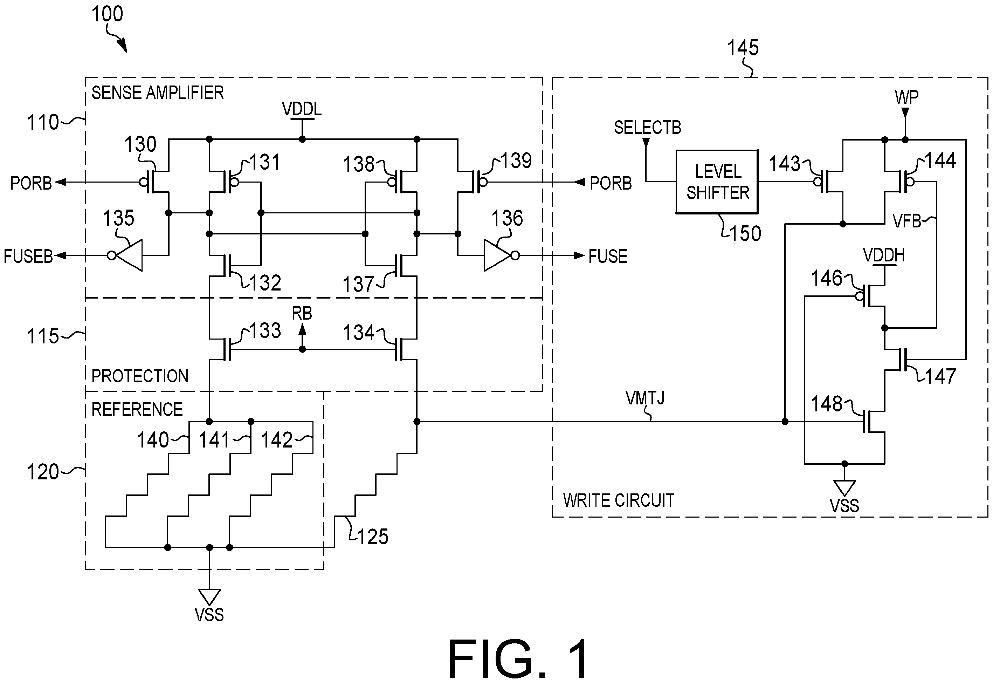

FIG. 1 illustrates an exemplary antifuse circuit 100 including a sense amplifier 110, a protection circuit 115, a reference circuit 120, an antifuse 125, and a write circuit 145. The antifuse 125 may be described as a magnetic tunnel junction (MTJ) device. Although the antifuse circuit 100 may be applicable to other types of antifuses or even fuses, an MTJ device may be particularly beneficial because of its relatively low voltage requirements for programming.

The sense amplifier 110 may include P channel transistor 130, P channel transistor 131, N channel transistor 132, inverter 135, inverter 136, N channel transistor 137, P channel transistor 138, and P channel transistor 139. The protection circuit 115 may include N channel transistor 133 and N channel transistor 134. The reference circuit 120 may include one or more MTJ devices 140, 141, and 142. FIG. 1 shows three MTJ devices in this embodiment, however, fewer (e.g., one) or more MTJ devices may be used. As described above, one or more resistors may alternatively be used in lieu of one or more MTJ devices, to set a reference resistance. The write circuit 145 may include P channel transistor 143, P channel transistor 144, P channel transistor 146, N channel transistor 147, N channel transistor 148, and a level shifter 150. The transistors described herein may be configured to handle different voltages, for example, transistors 133, 134, 143, 144, 146, 147, and 148 may be configured to handle a higher voltage, achieved by increasing the gate dielectric thickness. For example, P channel transistors 143, 144, and 146 may be configured to include a greater breakdown voltage than P channel transistors 130, 131, 138, and 139. Likewise, N channel transistors 133, 134, 147, and 148 may be configured to include a greater breakdown voltage than N channel transistors 132 and 137. It may be common for integrated circuits to have transistors with different breakdown voltages for the purpose of handling different voltages. The lower voltage breakdown transistors may be used for higher performance and lower power. For example, in a typical application the VDDL is for logic devices and VDDH is for input/output circuits. The sense amplifier 110 may be powered by a low power supply VDDL, and the write circuit 145 may be powered by a high power supply VDDH. A nominal voltage for VDDL may be 1.8 volts, and VDDH may be 3.3 volts.

P channel transistor 130 may include a gate for receiving a power on reset (POR) signal PORB (B may be used to indicate an active logic low signal), a source connected to VDDL, and a drain. Inverter 135 may include an input connected to the drain of P channel transistor 130 and an output for providing a complementary output signal FUSEB. P channel transistor 131 may include a source connected to VDDL, a drain connected to the drain of P channel transistor 130, and a gate. N channel transistor 132 may include a drain connected to the drain of P channel transistor 131, a gate connected to the gate of P channel transistor 131, and a source. P channel transistor 138 may include a source connected to VDDL, a gate connected to the drains of P channel transistor 131 and N channel transistor 132, and a drain. N channel transistor 137 may include a drain connected to the drain of P channel transistor 138, a gate connected to the gate of P channel transistor 138, and a source. P channel transistor 139 may include a source connected to VDDL, a gate for receiving POR signal PORB, and a drain connected to the drains of P channel transistor 138 and N channel transistor 137. Inverter 136 may include an input connected to the drain of P channel transistor 138, P channel transistor 139, and N channel transistor 137, and an output for providing output signal FUSE.

N channel transistor 133 may include a drain connected to the source of N channel transistor 132, a gate for receiving a read bias voltage RB, and a source. N channel transistor 134 may include a drain connected to the source of N channel transistor 137, a gate for receiving read bias voltage RB, and a source. Sense amplifier 110 and protection circuit 115 may together be considered a sensing circuit.

MTJ devices 140, 141, and 142 may each include a first terminal connected to a source of N channel transistor 133 and a second terminal connected to a negative power supply terminal (e.g., VSS, which may be ground). The antifuse 125 may include a first terminal connected to the source of N channel transistor 134 and a second terminal connected to VSS. The first terminal of the antifuse 125 may be configured to provide an MTJ voltage VMTJ for assisting in the control of current in write circuit 145.

The level shifter 150 may include an input for receiving a select signal SELECT B and an output. P channel transistor 143 may include a source for receiving a write power signal WP, a gate connected to the output of the level shifter 150, and a drain connected to the first terminal of the antifuse 125. P channel transistor 144 may include a source for receiving write power signal WP, a drain connected to the drain of P channel transistor 143, and a gate. P channel transistors 146 may include a source connected to VDDH, a drain connected to the gate of P channel transistors 144, and a gate connected to VSS. The drain of P channel transistors 146 may provide a foldback voltage VFB. N channel transistors 147 may include a drain connected to the drain of P channel transistors 146, a gate for receiving write power signal WP, and a source. N channel transistors 148 may include a drain connected to the source of N channel transistor 147, a gate connected to the first terminal of the antifuse 125, and a source connected to VSS.

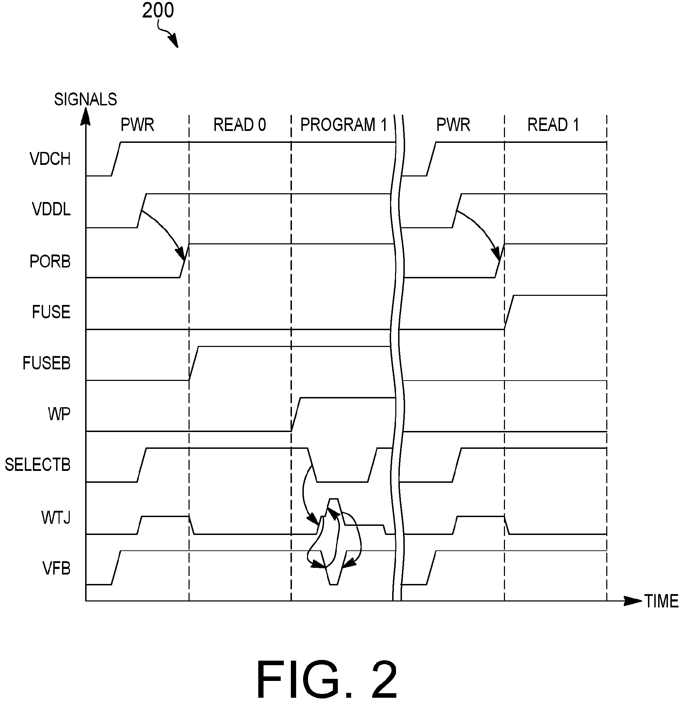

The operation of antifuse circuit 100 may be described in conjunction with the timing diagram 200 of FIG. 2. At power-up, POR signal PORB may be a logic low for a sufficient time for the power to stabilize and the circuits to respond. In this initial logic low condition, transistors 130 and 138 may be conductive causing inverters 135 and 136 to output a logic low. As VDDH and VDDL rise in voltage toward their ultimate voltage, the select signal SELECTB, MTJ voltage VMTJ, and foldback voltage VFB also rise. The rise of VDDL may be delayed in relation to the rise of VDDH. The rise in VDDL may be detected and, after an intended delay, POR signal PORB may be brought to the inactive logic high condition. In response to POR signal PORB becoming inactive, FUSE and FUSEB may become complementary and VMTJ may become a logic low. SELECTB may remain at a logic high in the inactive state.

In an example, antifuse 125 may not have been programmed initially, so may be read as a logic low (e.g., logic 0). The resistance of MTJ devices 140, 141, and 142 in parallel may be lower than the resistance of the antifuse 125. In some embodiments, the resistance of the MTJ devices (e.g., 140, 141, and 142) may be implemented using any other type of resistor, for example poly, diffusion, or nwell resistors. This may result in the drain of N channel transistor 132 being at a lower voltage than the drain of N channel transistor 137 at the time PORB releases control of sense amplifier 110 by switching to a logic high causing P channel transistors 130 and 139 connected between PORB to become non-conductive. This may include the sense amplifier 110 having a logic high on the drains of P channel transistor 138 and N channel transistor 137 to cause output signal FUSE to be at a logic low, and correspondingly the drains of P channel transistor 131 and N channel transistor 132 to be at a logic low to cause output signal FUSEB to be at a logic high. With SELECTB at a logic high, level shifter 150 may provide a logic high to P channel transistor 143 so that P channel transistor 143 may be non-conductive. The write power signal WP may be at a logic low so that N channel transistor 147 may be non-conductive. P channel transistor 146 connected to VDDH may be conductive to provide a logic high to the gate of P channel transistor 144 so that P channel transistor 144 may be non-conductive. With P channel transistor 143 and P channel transistor 144 being non-conductive, VMTJ may be controlled by antifuse 125.

In the case where antifuse 125 is programmed, as shown in FIG. 2, write power WP may be brought to the programming level, which may be substantially the same voltage that is at VDDH, (e.g., approximately 3.3 volts). P channel transistors 143 and 144 connected to the level shifter 150 may be non-conductive so that VMTJ is unchanged. After WP has been raised to the programming level, SELECTB may be brought to a logic low to initiate actual programming. In response to SELECTB being a logic low, level shifter 150 may provide a logic low to the gate of P channel transistor 143 causing P channel transistor 143 to become conductive. N channel transistor 147 may be conductive because of WP being at the programming level. N channel transistor 148 may also be conductive because P channel transistor 143 connected to the level shifter 150 may be conductive, and may provide a sufficiently high voltage to the gate of N channel transistor 147 to make it conductive. When N channel transistors 147 and 148 are conductive, the voltage at the gate of P channel transistor 144 may be sufficiently low to make P channel transistor 144 conductive. In this case, P channel transistor 144 may carry more current than P channel transistor 143. The purpose may be to bring the voltage level of VMTJ sufficiently high to breakdown the antifuse 125. When the antifuse 125 includes an MTJ, the breakdown voltage may be approximately 1.8 volts or lower. The voltage of VMTJ may be approximately 3.3 volts with both P channel transistors 143 and 144 connected to the level shifter 150 being conductive. N channel transistors 133 and 134 connected between read bias RB may be biased to prevent this high voltage from reaching sense amplifier 110. The voltage of read bias RB may include a threshold voltage above the voltage that is necessary for reliably reading the state of antifuse 125.

In this example, when the read bias RB is approximately 1.2 volts, which may be sufficiently low to ensure the MTJ breakdown is not reached during a read. This bias may not be changed between reading and programming. With VMTJ at 3.3 volts, sense amplifier 110 may be protected by protection circuit 115, and antifuse 125 breaks down and becomes greatly more conductive. A typical change for antifuse 125 being an MTJ device is from tens of thousands of ohms to hundreds of ohms, for example, from 20 thousand ohms to 2 hundred ohms. This may include the effect of reducing the voltage on the gate of N channel transistor 148 below its threshold voltage so that it becomes non-conductive. With N channel transistor 148 non-conductive, the drain of P channel transistor 146 may become a logic high which may cause P channel transistor 144 to become non-conductive. With P channel transistor 144 non-conductive, current through antifuse 125 may be limited by the current through P channel transistor 143. This may reduce the load on write power WP signal so that other circuits may be able to receive more current from write power signal WP. The continuing flow of current through antifuse 125 being achieved through P channel transistor 143 may be believed to be beneficial in ensuring that antifuse 125 achieves at least the low resistance that is expected.

The FUSE and FUSEB outputs probably will not change during programming because sense amplifier 110 is a latch. Thus, after programming, the power needs to be reset. As previously described for switching the power on, POR signal PORB is generated at a logic low that keeps the drains of P channel transistor 131 and N channel transistor 137 both at the same voltage which may be recognized as a logic high by inverters 135 and 136. During the active portion of PORB, SELECTB is raised to a logic high so that P channel transistor 143 may be non-conductive. After VDDL has reached its desired level for a predetermined delay time, POR signal PORB is brought to the inactive logic high state. At this point in time, the drains of N channel transistors 132 and 137 may be held at substantially the same voltage by P channel transistors 130 and 139 but P channel transistor 138 may be carrying more current than P channel transistor 131 due to the resistance of antifuse 125 being lower than that of reference circuit 120. Thus P channel transistor 138 may drop more voltage than P channel transistor 131 so that the voltage on the drain of N channel transistor 137 may be at a little lower voltage than the voltage on the drain of N channel transistor 132 at the time P channel transistors 130 and 139 become non-conductive due to PORB going to a logic high. Sense amplifier 110 may then latch with the voltage on the drain of N channel transistor 137 at the relatively lower voltage so that a logic low is latched onto the drain of N channel transistor 137 and a logic high is latched onto the drain of N channel transistor 132. In this condition FUSE is a logic high and FUSEB is a logic low. Write circuit 145 may include P channel transistors 143 and 144 and N channel transistors 147 and 148 in a non-conductive state. P channel transistor 146 may be conductive but may be in series with transistors that are non-conductive so does not draw current.

The use of one or more MTJ devices (e.g., 140, 141, and 142) in parallel may ensure that the reference circuit 120 may include a resistance that is well below that of the antifuse 125 when unprogrammed. In some embodiments, any type of resistor, such as poly, diffusion, or nwell resistors may be used instead of one or more MTJ devices (e.g., 140, 141, and 142). In the unprogrammed state, the resistance of the antifuse 125 may vary substantially due in part to process variation but also because of the variable magnetic character of an MTJ device. The resistance of the MTJ device may differ based on that magnetic state. It may be this difference in resistance based on magnetic state that makes it useful as part of a memory cell in a memory array. Thus, by its nature an MTJ may not be predictable as to its resistance. Thus, even the three references may be in different magnetic state. The worst case condition may be when the reference MTJs are in the high resistive magnetic state and the antifuse is in the low resistive magnetic state. In the case of three MTJs in parallel, the reference is safely lower in resistance than the antifuse. The programmed state may be achieved in a non-reversible process that physically alters the MTJ and so it may be less of concern. Even if all three reference MTJs are in the magnetic state of low resistance, they are safely above the resistance of any successfully programmed antifuse.

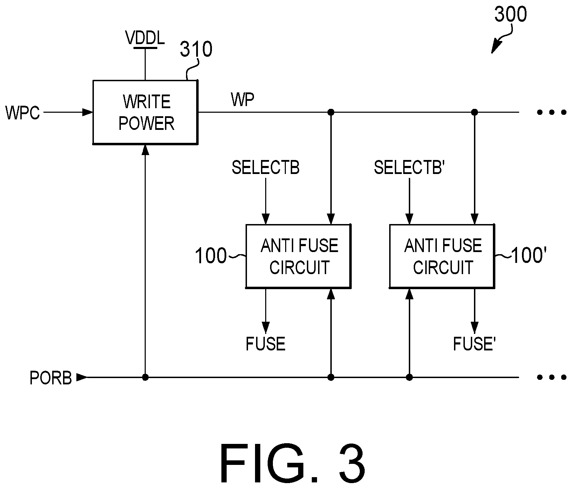

FIG. 3 illustrates an antifuse system 300 comprising a write power circuit 310, an antifuse circuit 100, and an antifuse circuit 100'. The antifuse circuit 100 may be substantially similar to the antifuse circuit of FIG. 1 described above. The antifuse system 300 may include additional antifuse circuits not shown. The antifuse circuit 100' may be constructed the same as the antifuse circuit 100 with the only difference being it may receive a different SELECT signal. The antifuse circuits not shown may also be constructed the same as antifuse circuit 100. In the case of antifuse circuit 100', it may receive a SELECT B' signal. In a programming operation, write power circuit 310 may include a limited current drive capability. As the antifuse circuits that have relatively easy MTJs for programming are programmed, the current required for those may be reduced by the foldback operation in the write circuits (e.g., write circuit 145). For example, in antifuse circuit 100, the one or more transistors 130 may become non-conductive to reduce the current required from write power signal WP allowing more current to be supplied to other antifuse circuits. Thus the write power circuit 310 may be designed with a sufficiently high power capability to program the easy MTJs and with each successful programming, more power is available for programming the remaining MTJs. Especially since it is only a few MTJs that are typically difficult and the difference between difficult and easy is relatively large, it can be a significant savings in the area required on the integrated circuit for write power circuit 310 to use the foldback technique of write circuit 145 to only supply limited power initially then using the increased power availability as MTJs are programmed to program the difficult MTJs.

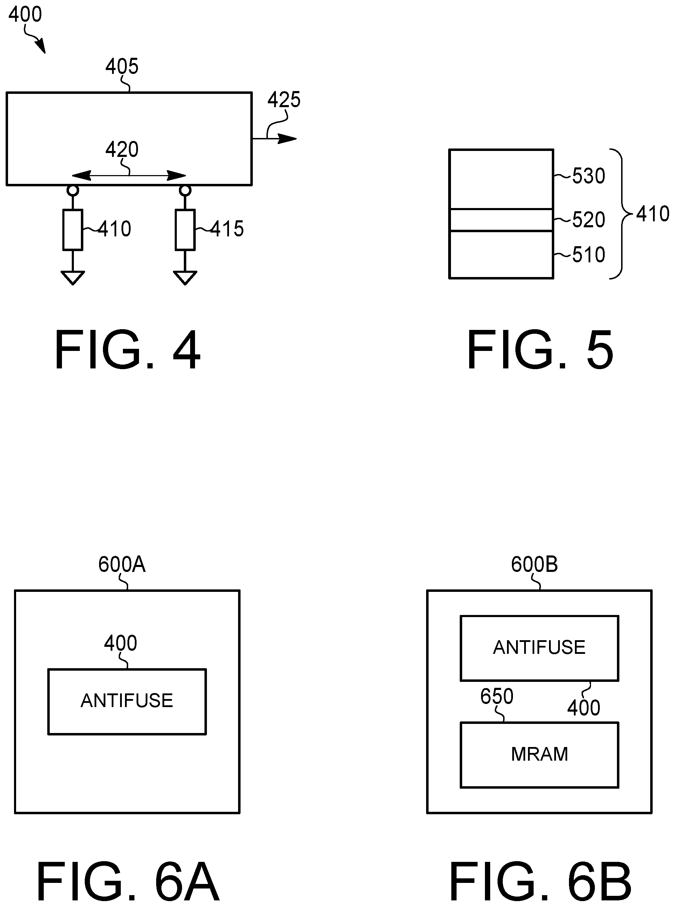

FIG. 4 illustrates an exemplary antifuse circuit 400. The antifuse circuit 400 may include a sensing block 405, an antifuse device 410, a reference resistor 415, and an output 425. The sensing block 405 may be configured to compare the difference in resistance 420 (and, therefore, the difference in electrical conductivity) between the antifuse device 410 and the reference resistor 415. The logical state of the sensing block 405 may be determined based on a comparison of a first resistance of the antifuse device 410 and a second resistance of the reference resistor 415. The sensing block 405 may output a logical state (e.g., logical 0 or logical 1) corresponding to the resistance of the antifuse device 410. For example, the resistance of the reference resistor 415 may be 1,000Ω. When the resistance of the antifuse device 410 is 675Ω (e.g., less than the resistance of the reference resistor 415), the output 425 may be one of the two logical states (e.g., a logical 1). When the resistance of the antifuse device 410 is 1,675Ω (e.g., more than the resistance of the reference resistor 415), the output 425 may be the other of the two logical states (e.g., a logical 0). Based on such a comparison, the sensing block 405 may output a logical state of the antifuse circuit 400. However, if the antifuse circuit 400 includes manufacturing defects, which may change the electrical characteristics (e.g., the conductive resistance) of the antifuse device 410, the results of the comparison may be undesirably and unintentionally altered.

FIG. 5 illustrates an exemplary structure of the antifuse device 410 described above with respect to FIG. 4. The antifuse device 410 may be integrated on an integrated circuit (IC) die. The antifuse device 410 may include an MTJ-like stack including an antifuse bit, where the antifuse bit includes a first metal layer 510, an insulator layer 520 above the first metal layer 510, and a second metal layer 530 above the insulator layer 520. The first metal layer 510 and the second metal layer 530 may include a non-magnetic conductive material (e.g., aluminum, copper, lead, tin or the like). By including non-magnetic conductive layers (e.g., the first metal layer 510 and the second metal layer 530) on either side of an insulator layer (e.g., insulator layer 520), the MTJ-like stack may be less complex and less prone to defects and failure when used as an antifuse. Moreover, compared to resistor-based designs, the MTJ-like stack including the antifuse bit, as described herein, may require a lower voltage to program.

The first metal layer 510 and the second metal layer 530 may conduct electrical current thereacross after the insulator layer 520 therebetween is disrupted. Thus, when the insulator is blown, the first metal layer 510 and the second metal layer 530 may become permanently electrically connected (e.g., may conduct an electrical current from one to another), allowing continuous conduction of electrical current. As a result, the antifuse bit may function as a permanent conductor. In embodiments disclosed herein, the first metal layer 510 and the second metal layer 530 may include substantially the same or different material compositions. For example, the first metal layer 510 and the second metal layer 530 may each include tantalum. The first metal layer 510 and the second metal layer 530 may include any known or future non-magnetic conductive material.

The insulator layer 520 may initially act as a resistive (e.g., non-conductive) barrier between the first metal layer 510 and the second metal layer 530. That is, while the insulator layer 520 is between the first metal layer 510 and the second metal layer 530, electrical current will not flow from the first metal layer 510 to the second metal layer 530 and vice versa. Once disrupted, the insulator layer 520 may no longer act as a resistive barrier and the first metal layer 510 and the second metal layer 530 will conduct electrical current. In some embodiments, the insulator layer 520 may be in contact with the first metal layer 510, and the second metal layer 530 may be in contact with the insulator layer 520. For example, the insulator layer 520 may include a conductive resistance of less than 3,000Ω. The insulator layer 520 may include any known or future resistive or insulating material (e.g., aluminum oxide or magnesium oxide). For example, the material and the configuration of the insulator layer 520 may be the same or substantially similar to those of the tunnel barriers typically used in an MRAM memory element.

FIG. 6A illustrates an exemplary IC die 600A. The IC die 600A may include the antifuse circuit 400. The antifuse circuit 400 may include some or all of the components (e.g., sensing block, antifuse device, reference resistor, output, or the like) as described in FIGS. 4-5. Specifically, one or more layers of the IC die 600A may include the antifuse device 410 comprising an antifuse bit in the form of an MTJ-like stack as described above in reference to FIG. 5. Therefore, one or more layers of the IC die 600A may include one or more antifuse bits, each antifuse bit including a first metal layer 510, an insulator layer 520 above the first metal layer 510, and a second metal layer 530 above the insulator layer 520. As illustrated in FIG. 6A, the IC die 600A may include the antifuse circuit 400 and may not include other MRAM layers.

FIG. 6B illustrates another exemplary IC die 600B. The IC die 600B may include one or more layers including the antifuse circuit 400 and an MRAM 650 including memory elements (e.g., MRAM array(s)). A first portion of the one or more layers may include the antifuse circuit 400 with no other memory elements. A subset of that first portion may include the antifuse device 410 comprising an antifuse bit in the form of an MTJ-like stack as described above in reference to FIG. 5. The subset of the first portion of the one or more layers of the IC die 600B may thus include one or more antifuse bits, each antifuse bit including a first metal layer 510, an insulator layer 520 above the first metal layer 510, and a second metal layer 530 above the insulator layer 520. A second portion of the one or more layers may include the MRAM 650. Therefore, the IC die 600B may include memory element layers (e.g., one or more layers each include one or more memory bits/elements) in addition to antifuse layers.

The fuse described herein may be implemented on any integrated circuit. In some embodiments, the fuse described herein may be formed on an integrated circuit die that may or may not include a memory region. Such memory regions may include, but are not limited to, e.g., an MRAM array.

In one embodiment, the present disclosure is drawn to an antifuse device comprising: an antifuse bit including: a first non-magnetic conductive layer; an insulator above the first non-magnetic conductive layer; and a second non-magnetic conductive layer above the insulator.

Various aspects of the present disclosure may also include one or more of the following features: wherein the antifuse bit is on an integrated circuit (IC) die, wherein the IC die does not include any memory layer; wherein the antifuse bit is on an IC die, wherein the IC die includes at least one memory layer; wherein the antifuse bit is on an IC die with at least one memory layer, the at least one memory layer including a magnetoresistive random access memory (MRAM) array; wherein the insulator is in contact with the first non-magnetic conductive layer and the second non-magnetic conductive layer; wherein the first non-magnetic conductive layer and the second non-magnetic conductive layer include different one or more materials; wherein the first non-magnetic conductive layer and the second non-magnetic conductive layer include same one or more materials; wherein the first non-magnetic conductive layer and the second non-magnetic conductive layer each include tantalum; wherein the insulator includes aluminum oxide or magnesium oxide; and wherein the insulator includes a resistance of less than 3,000Ω.

In another embodiment, the present disclosure is drawn to an antifuse circuit comprising: a sensing block; an antifuse device including an antifuse bit and electrically connected to the sensing block; and a reference resistor electrically connected to the sensing block, wherein a logical state of the sensing block includes one of a first logical state if the antifuse bit is programmed or a second logical state if the antifuse bit is unprogrammed.

Various aspects of the present disclosure may also include one or more of the following features: wherein the logical state of the sensing block is determined based on a comparison of a first resistance of the antifuse bit with a second resistance of the reference resistor; wherein the antifuse bit includes: a first metal layer; an insulator above the first metal layer; a second metal layer above the insulator, wherein the first metal layer and the second metal layer are non-magnetic; wherein the antifuse circuit is implemented on an IC die that does not include any memory layer; and wherein the antifuse circuit is implemented on an IC die that includes one or more memory layers.

In yet another embodiment, the present disclosure is drawn to a die comprising: one or more first layers each including one or more antifuse bits, wherein each of the one or more antifuse bits includes: a first non-magnetic conductive layer; an insulator above the first non-magnetic conductive layer; and a second non-magnetic conductive layer above the insulator.

Various aspects of the present disclosure may also include one or more of the following features: the die further comprising one or more second layers each including a memory layer, wherein the memory layer includes a magnetoresistive random access memory (MRAM) array; wherein the insulator includes same one or more materials as those of a tunnel barrier used in an MRAM; wherein the first non-magnetic conductive layer and the second non-magnetic conductive layer include different one or more materials; and wherein the first non-magnetic conductive layer and the second non-magnetic conductive layer include same one or more materials.

Other embodiments of the disclosure will be apparent to those skilled in the art from consideration of the specification and practice of the embodiment(s) disclosed herein. It is intended that the specification and examples be considered as exemplary only, with a true scope and spirit of the embodiment(s) being indicated by the following claims.

While exemplary embodiments have been presented above, it should be appreciated that many variations exist. Furthermore, while the description includes references to MRAM devices, the teachings may be applied to other memory devices having different architectures in which the same concepts can be applied. Thus, the particular embodiments disclosed above are illustrative only and should not be taken as limitations, as the embodiments may be modified and practiced in different but equivalent manners apparent to those skilled in the art having the benefit of the teachings herein. Accordingly, the foregoing description is not intended to limit the disclosure to the particular form set forth, but on the contrary, is intended to cover such alternatives, modifications and equivalents as may be included within the spirit and scope of the inventions as defined by the appended claims so that those skilled in the art should understand that they can make various changes, substitutions and alterations without departing from the spirit and scope of the inventions in their broadest form.

The foregoing description of the inventions has been described for purposes of clarity and understanding. It is not intended to limit the inventions to the precise form disclosed. Various modifications may be possible within the scope and equivalence of the application.

## Claims

1. An antifuse device comprising:
an antifuse bit including:
a first non-magnetic conductive layer;
an insulator above the first non-magnetic conductive layer; and
a second non-magnetic conductive layer above the insulator,
wherein when the insulator is disrupted, the first non-magnetic conductive layer and the second non-magnetic conductive layer permanently conduct an electrical current from one to another.

2. The antifuse device of claim 1, wherein the antifuse bit is on an integrated circuit (IC) die, wherein the IC die does not include any memory layer.

3. The antifuse device of claim 1 or 2, wherein the antifuse bit is on an IC die,
wherein the IC die includes at least one memory layer, in particular,
wherein the antifuse bit is on an IC die with at least one memory layer, the at least one memory layer including a magnetoresistive random access memory (MRAM) array.

4. The antifuse device of one of claims 1 to 3, wherein the insulator is in contact with the first non-magnetic conductive layer and the second non-magnetic conductive layer.

5. The antifuse device of one of claims 1 to 4, wherein the first non-magnetic conductive layer and the second non-magnetic conductive layer include different one or more materials, and/or
same one or more materials, and/or
each include tantalum.

6. The antifuse device of one of claims 1 to 5, wherein the insulator includes
aluminum oxide or magnesium oxide, and/or
wherein the insulator includes a resistance of less than 3,000Ω.

7. An antifuse circuit comprising:
a sensing block;
an antifuse device including an antifuse bit and electrically connected to the sensing block; and
a reference resistor electrically connected to the sensing block,
wherein a logical state of the sensing block includes one of a first logical state if the antifuse bit is programmed or a second logical state if the antifuse bit is unprogrammed.

8. The antifuse circuit of claim 7, wherein the logical state of the sensing block is determined based on a comparison of a first resistance of the antifuse bit with a second resistance of the reference resistor.

9. The antifuse circuit of claim 7 or 8, wherein the antifuse bit includes:
a first metal layer;
an insulator above the first metal layer;
a second metal layer above the insulator,
wherein the first metal layer and the second metal layer are non-magnetic.

10. The antifuse circuit of one of claims 7 to 9, wherein the antifuse circuit is implemented on an IC die that does not include any memory layer, or alternatively that includes one or more memory layers.

11. A die comprising:
one or more first layers each including one or more antifuse bits,
wherein each of the one or more antifuse bits includes:
a first non-magnetic conductive layer;
an insulator above the first non-magnetic conductive layer; and
a second non-magnetic conductive layer above the insulator.

12. The die of claim 11, further comprising:
one or more second layers each including a memory layer, wherein the memory layer includes a magnetoresistive random access memory (MRAM) array.

13. The die of claim 11 or 12, wherein the insulator includes same one or more materials as those of a tunnel barrier used in an MRAM.

14. The die of one of claims 11 to 13, wherein the first non-magnetic conductive layer and the second non-magnetic conductive layer include different one or more materials.

15. The die of one of claims 11 to 14, wherein the first non-magnetic conductive layer and the second non-magnetic conductive layer include same one or more materials.
